# EUROPEAN PATENT APPLICATION

(11) **EP 4 336 973 A1**
(43) Date of publication of application: **13.03.2024**
(21) Application number: 22194318.6
(22) Date of filing: 07.09.2022
(51) Int. Cl.: H05K 1/02, H05K 1/18, B60Q 1/00

(54) **ELECTRONIC SUBSTRATE AND AUTOMOTIVE LIGHTING DEVICE FOR AN AUTOMOTIVE VEHICLE**

(71) Applicant: Valeo Vision, 93012 Bobigny Cedex (FR)
(72) Inventor: CANTUDO FRANCO, Miguel Angel, 23600 Martos (ES); JURADO TRUJILLO, Jesus, 23600 Martos (ES)
(74) Representative: Valeo Visibility

(57) **Abstract**

The invention is related to an electronic substrate (1) for an automotive lighting device. This electronic substrate (1) comprises a power input (2), a control unit (3) and first and second circuits, connecting, by their corresponding set of conductive tracks (4, 5), the power input (2) with a first input of the control unit (3). The substrate also comprises two frangible portions (6, 8), each one comprising a portion of the substrate (1) and a portion of the corresponding set of conductive tracks (4, 5), wherein each frangible portion (6, 8) comprises a breaking line (7) which has a mechanical resistance lower than the rest of the substrate (1).

## Description

The present invention generally relates to an electronic substrate for a lighting device of a vehicle and to a lighting device comprising such a substrate.

Lighting devices are an integral part of automotive vehicles. The lighting devices may be of various types such as headlamps, tail lamps, signal lamps, and the like, which may be used for different functions of the automotive vehicle. The lighting device of an automotive vehicle may perform different lighting functions such as providing a low beam, a high beam, a turn signal indicator, daytime running lamps, tail light, turn signal indication, fog light, and the like by utilizing the lighting device. The lighting device is configured to provide different light output for different lighting functions by utilizing an electronic assembly. The electronic assembly is connected between a power supply and a light source of the lighting device. The electronic assembly receives the power supply from the battery of the vehicle as power input and transforms this power input into a signal which is suitable for the lighting device to provide different lighting functions.

Usually, the automotive brand may have different models, each model having in turn different versions, depending on consumer demand. Further, different countries have different lighting regulations, so the same model in the same version may have two alternatives (e.g. for EU and for US). Each version and variant of the automotive vehicle may have the same or different lighting functions. For example, a high end version of the vehicle may provide a signature lighting function whereas a low end version of the same vehicle may not provide the signature lighting function due to cost consideration, but may have the same lighting functions as the medium range version. In this case, the structure remains very similar, causing the assembly operator to be easily mistaken with the different versions of very similar circuit boards.

The "background" description provided herein is for purposes of presenting the general context of the disclosure. Work of the presently named inventors, to the extent it is described in this background section, as well as aspects of the description, which may not otherwise qualify as conventional art at the time of filing, are neither expressly nor impliedly admitted as conventional art against the present disclosure.

The present invention is directed to an improved electronic substrate for a vehicle that solves the aforementioned problem.

In a first inventive aspect, the invention provides an electronic substrate for an automotive lighting device, the electronic substrate comprising
- a power input;
- a control unit;
- a first circuit connecting, by a first set of conductive tracks, the power input with a first input of the control unit;
- a second circuit connecting, by a second set of conductive tracks, different from the first set of conductive tracks, the power input with a second input of the control unit;
- a first frangible portion which comprises a portion of the substrate and a portion of the first set of conductive tracks, wherein the first frangible portion comprises a breaking line which has a mechanical resistance lower than the rest of the substrate; and
- a second frangible portion which comprises a portion of the substrate and a portion of the second set of conductive tracks, wherein the second frangible portion comprises a breaking line which has a mechanical resistance lower than the rest of the substrate.

This invention allows the provision of a single reference of an electronic substrate for different variations of lighting devices, due to different versions or country specifications (ECE, FMVSS, etc). When a specific version is chosen, this specific version corresponds to a specific input in the control unit. The circuit that connects this specific input with the power input is the circuit that should be preserved. The rest of the circuits should be open, so that no other input is fed in the control unit. This is achieved by removing the frangible parts of the circuits which are not chosen.

With this invention, a single reference is provided to face different options, thus saving time and cost. The differentiation is done in the assembly line, just by removing one or more parts from the substrate.

In some particular embodiments, the electronic substrate further comprises
- at least a further circuit, each further circuit connecting, by their corresponding set of conductive tracks, the power input with the control unit; and
- at least a further frangible portion, each frangible portion comprising a portion of the substrate and a portion of the corresponding set of conductive tracks, wherein each frangible portion comprises a breaking line which has a mechanical resistance lower than the rest of the substrate.

The provision of a greater number of circuits, with their corresponding frangible portions, provides a way of different car models, different versions, different regulations...). It is easy that for the same substrate reference, 8, 10 or 12 different options may be available.

In some particular embodiments, at least one set of conductive tracks comprises a zero-ohm resistor suitable for reducing corrosion.

In some particular embodiment, each frangible portion is codified with an attribute. Thus, it is easier for the operator to easily identify the portions to be detached. In some particular embodiments, the attributes comprises at least one of colour, pattern or shape.

In some particular embodiments, at least one frangible portion is located in a corner of the substrate. With this location, it is easier to detach the frangible portion.

In some particular embodiments, the substrate is a printed circuit board.

In a second inventive aspect, the invention provides an automotive lighting device comprising:
- an electronic substrate according to the first inventive aspect;
- at least one light source arranged in the electronic substrate to be controlled by the control unit; and
- a housing configured to receive the substrate, the housing comprising at least one control part configured to prevent the substrate to be installed in the housing unless at least one of the plurality of frangible portions are removed from the substrate.

This automotive lighting device may be designed with its own housing, which is specifically adapted for the model, version and standard regulation. The housing itself comprises a physical control part intended to prevent a wrong configuration of the electronic substrate.

In some particular embodiments, the light source is a solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

In some particular embodiments, the automotive lighting device is configured to provide a rear lamp function, a stop lamp function, a rear direction indicator lamp function and a fog lamp function.

A rear device is more prompt to suffer from these variations in functionalities and regulations. However, this invention may be applied to a headlamp as well.

In a further inventive aspect, the invention provides a method of assembling an automotive lighting device, the method comprising the steps of:
- providing an electronic substrate according to the first inventive aspect;
- removing at least one of the frangible portions from the electronic substrate, thus opening the corresponding circuit; and
- installing the electronic substrate with the removed portion in a housing comprising at least one control part configured to correspond with the location of the removed portion.

In this method, the operator knows which portions should be detached from the substrate for each specific portion. This is suitable when the assembly line is dedicated to a single model and version and the operation is repetitive.

In a further inventive aspect, the invention provides a method of assembling an automotive lighting device, the method comprising the steps of:
- providing an electronic substrate according to the first inventive aspect; and
- installing the electronic substrate in a housing comprising at least one control part, each control part being configured to break one frangible portion when the electronic substrate is installed in the housing.

In this method, the operator does not need to know which portions should be detached from the substrate for each specific portion, since the housing is the one which detaches the portions corresponding to non-chosen options. This is suitable when the assembly line is not dedicated to a single model and version, so that the operation changes constantly.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

To further provide a more encompassing description and a better understanding of the invention, a set of drawings is provided. Said drawings form an integral part of the description and illustrate embodiment aspects of the invention, which should not be construed as restricting the scope of the invention, but only as examples of how the invention can be carried out. The drawings comprise the following characteristics:

FIG. 1 shows an electronic assembly for a vehicle, according to an embodiment of the present invention.

FIG. 2 shows the particular location of the housing where the printed circuit board is to be installed.

In these figures, the following reference numbers have been used:
- 1 Printed circuit board
- 2 Power input
- 3 Control unit
- 4 First set of conductive tracks
- 5 Second set of conductive tracks
- 6 First frangible portion
- 7 Breaking line
- 8 Second frangible portion
- 9 Third set of conductive tracks
- 10 Fourth set of conductive tracks
- 11 Third frangible portion
- 12 Fourth frangible portion
- 13 Zero-ohm resistor
- 14 LED
- 15 Housing
- 16 Physical control parts

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

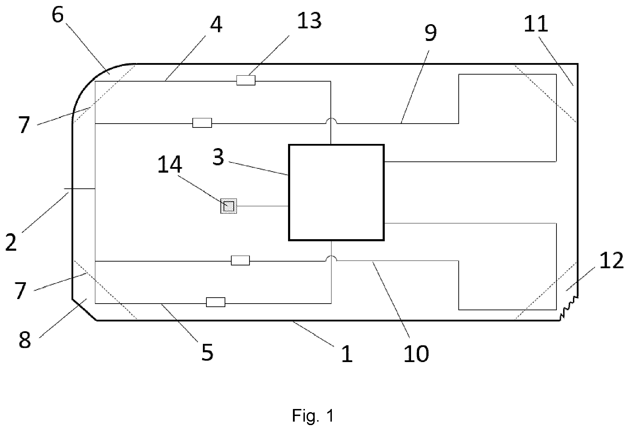

FIG.1 shows a printed circuit board 1 according to the invention. This printed circuit board 1 is intended to be installed in an automotive lighting device, as will be shown later. This printed circuit board 1 comprises a power input 2 and a control unit 3.

The power input 2 is common for this type of elements: a 3.3V input, a 5V input or a 12V input are typical examples of the power feeding of these elements. The control unit 3 is in charge of controlling a group of LEDs which are intended to provide different lighting and signalling functions.

This printed circuit board 1 comprises four different circuits. Each one of these four different circuits corresponds to a configuration option. For example, first and second circuits may correspond to ECE versions, while third and fourth circuits may correspond to an FMVSS version. First and third circuits may correspond to basic versions while second and fourth circuits may correspond to premium versions.

Each circuit has a set of conductive tracks which connect the same power input 2 with a corresponding input of the control unit 3. The control unit 3 recognizes which is the fed input and then provides the required functionalities corresponding to the chosen option.

The printed circuit board 1 also comprises a plurality of frangible portions 6, 8, 11, 12, one per each circuit, in such a way that every circuit may be opened by detaching the corresponding frangible portion, due to the fact that the frangible portion comprises a portion of the conductive tracks of the corresponding circuit. Hence, the first frangible portion 6 comprises a portion of the first set of conductive tracks 4, and accordingly, the rest of the frangible portions 8, 11, 12 comprises a portion of the corresponding set of conductive tracks 5, 9, 10.

Then, when a specific model and version is to be assembled, only one circuit provides the specific configuration, the detachable portions corresponding to the rest of the options should be detached, before installing or when installing the printed circuit board in the lighting device.

Each circuit comprises a zero-ohm resistor 13, suitable for reducing corrosion.

In the embodiment of the figure, the printed circuit board comprises four frangible portions 6, 8, 11, 12, each one being located in one corner of the printed circuit board 1. Each detachable portion may be identified with a different colour, a different pattern (tactile pattern, for example) or a different shape, as in the present figure. Top left frangible portion 6 has a rounded finish, top right frangible portion 11 has a sharp finish, bottom left frangible portion 8 has a beveled finish and bottom right frangible portion 12 has a saw-teeth finish. Hence, each portion may be easily identifiable even without needing to look at the portion itself.

Each frangible portion has a breaking line 7, which is prepared to break in the event of a pressure over it, since it has a mechanical resistance lower than the rest of the printed circuit board 1. This may be achieved by a lower thickness, or by small through holes which weakens the breaking line.

When installing the printed circuit board 1 in the housing to form the lighting device, there are two main options.

First option is that the operator manually detaches the frangible portions corresponding to the non-chosen options, thus leaving only the frangible portion which corresponds to the chosen option. Then, once the printed circuit board is prepared, then is installed in the housing.

Hence, if the vehicle where the printed circuit board is going to be installed has a premium version and is to be sold in EU market, the second circuit is chosen, and the frangible portions corresponding to the rest of the circuits will be detached.

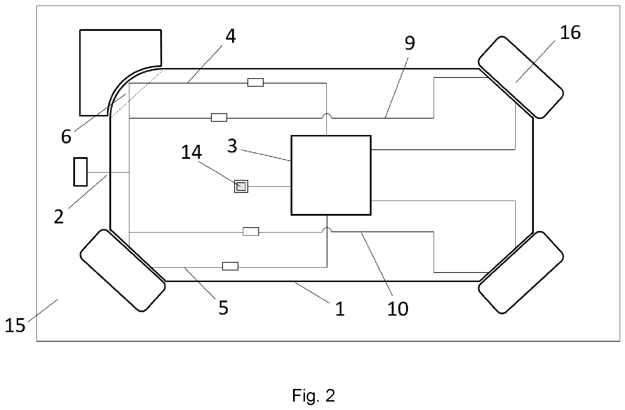

Figure 2 shows the particular location of the housing where the printed circuit board is to be installed. In this case, the housing comprises some physical control parts which takes the space of the detached portions, so that the printed circuit board cannot be installed in the housing if the correct configuration is not chosen (i.e., if the frangible portions corresponding to the non-chosen configuration have not been all detached).

This configuration may be also used in a different embodiment of the method of assembling the lighting device.

In this second embodiment, the operator just takes the printed circuit board 1 and presses it against the housing. The control parts will cause the frangible portions to detach, due to the pressure of the operator against them, and due to the fact that the breaking line has a lower mechanical resistance.

## Claims

1. An electronic substrate (1) for an automotive lighting device, the electronic substrate (1) comprising
a. a power input (2);
b. a control unit (3);
c. a first circuit connecting, by a first set of conductive tracks (4), the power input (2) with a first input of the control unit (3);
d. a second circuit connecting, by a second set of conductive tracks (5), different from the first set of conductive tracks (4), the power input (2) with a second input of the control unit (3);
e. a first frangible portion (6) which comprises a portion of the substrate (1) and a portion of the first set of conductive tracks (4), wherein the first frangible portion (6) comprises a breaking line (7) which has a mechanical resistance lower than the rest of the substrate (1); and
f. a second frangible portion (8) which comprises a portion of the substrate (1) and a portion of the second set of conductive tracks (5), wherein the second frangible portion comprises a breaking line which has a mechanical resistance lower than the rest of the substrate (1).

2. The electronic substrate (1) according to claim 1, further comprising
a. at least a further circuit, each further circuit connecting, by their corresponding set of conductive tracks (9, 10), the power input with the control unit (3); and
b. at least a further frangible portion (11, 12), each frangible portion comprising a portion of the substrate and a portion of the corresponding set of conductive tracks (9, 10), wherein each frangible portion comprises a breaking line (7) which has a mechanical resistance lower than the rest of the substrate (1).

3. The electronic substrate (1) according to any of the preceding claims, wherein at least one set of conductive tracks (4, 5, 9, 10) comprises a zero-ohm resistor (13) suitable for reducing corrosion.

4. The electronic substrate (1) according to any of the preceding claims, wherein each frangible portion (6, 8, 11, 12) is codified with an attribute.

5. The electronic substrate (1) according to claim 4, wherein the attributes comprises at least one of colour, pattern or shape.

6. The electronic substrate (1) according to any of the preceding claims, wherein at least one frangible portion (6, 8, 11, 12) is located in a corner of the substrate (1).

7. The electronic substrate (1) according to any of the preceding claims, wherein the substrate (1) is a printed circuit board.

8. An automotive lighting device comprising:
a. an electronic substrate (1) according to any of the preceding claims;
b. at least one light source (14) arranged in the electronic substrate (1) to be controlled by the control unit (3);
c. a housing (15) configured to receive the substrate (1), the housing comprising at least one control part (16) configured to prevent the substrate to be installed in the housing (15) unless at least one of the plurality of frangible portions (6, 8, 11, 12) are removed from the substrate (1).

9. The automotive lighting device according to claim 8, wherein the light source (14) is a solid-state light source.

10. The automotive lighting device according to any of claims 8 or 9, being configured to provide a rear lamp function, a stop lamp function, a rear direction indicator lamp function and a fog lamp function.

11. A method of assembling an automotive lighting device, the method comprising the steps of:
a. providing an electronic substrate (1) according to any of claims 1 to 7;
b. removing at least one of the frangible portions from the electronic substrate (1), thus opening the corresponding circuit; and
c. installing the electronic substrate with the removed portion in a housing comprising at least one control part configured to correspond with the location of the removed portion.

12. A method of assembling an automotive lighting device, the method comprising the steps of:
a. providing an electronic substrate (1) according to any of claims 1 to 7; and
b. installing the electronic substrate in a housing comprising at least one control part, each control part being configured to break one frangible portion when the electronic substrate (1) is installed in the housing.
